Europäisches Patentamt

European Patent Office

Office européen des brevets

(19)

(11) Publication number: **0 029 747**

**A1**

(12) # EUROPEAN PATENT APPLICATION

(21) Application number: **80304246.4**

(22) Date of filing: **26.11.80**

(51) Int. Cl.³: **C 23 C 13/00**

(30) Priority: 27.11.79 JP 152455/79
27.11.79 JP 152456/79
27.11.79 JP 152457/79
14.06.80 JP 79613/80
14.06.80 JP 79614/80
14.06.80 JP 79615/80
14.06.80 JP 79616/80

(43) Date of publication of application:
03.06.81 Bulletin 81/22

(84) Designated Contracting States:
DE FR GB

(71) Applicant: KONISHIROKU PHOTO INDUSTRY CO. LTD.
No. 26-2, Nishishinjuku 1-chome Shinjuku-ku
Tokyo(JP)

(72) Inventor: Shindo, Masanari
1001 Nishiterakata-machi
Hachioji-shi Tokyo(JP)

(72) Inventor: Myokan, Isao
2-5-19 Ohwada-machi
Hachioji-shi Tokyo(JP)

(74) Representative: Ellis-Jones, Patrick George
Armine et al,
J.A. KEMP & CO. 14 South Square Gray's Inn
London WC1R 5EU(GB)

(54) An apparatus for vacuum deposition and a method for forming a thin film by the use thereof.

(57) A method of and apparatus for vacuum deposition of a film on a substrate from a vapour source employing a chamber (1), and an exhaust path (2) by which the chamber can be evacuated, characterised by a discharge tube (4) for activating or ionizing a gas, said discharge tube (4) being connected to said chamber (1) so that an activated or ionized gas may be introduced into said chamber (1).

FIG. I

AN APPARATUS FOR VACUUM DEPOSITION AND A METHOD FOR FORMING
A THIN FILM BY THE USE THEREOF

The present invention relates to an apparatus for
vacuum deposition and a method for forming a thin film by
the use of said apparatus.

Vacuum evaporation is known to be one of the useful
means to form a thin film on a certain substrate.  The
composition of the film formed by means of this method
depends upon the nature of a substance used as a vapor
source.  In this method, therefore, it is not always easy
to form a film comprising two or more different substances
unless all those different substances can be evaporated,
and also it is normally difficult to perform high speed
film formation by means of vacuum deposition.

Heretofore, as a method to introduce a third component
into a film which consists mainly of a certain substance
such as metal, such a method has been known, that is, a
decomposable gas is introduced into a vacuum chamber in
which evaporation of a substance from a vapor source takes
place and then thus decomposed element of the gas is incorporated into the film.  However, it is extremely
difficult in this method to control the decomposition of
the gas and, moreover, concentration of the decomposed product is normally extremely low, therefore it is practically impossible to introduce such third component at a desired concentration in a high speed film making process.

It is, therefore, a primary object of the invention to provide an apparatus for vacuum deposition by which a high speed thin film forming process by means of vacuum deposition, wherein incorporation of such third component into said thin film is required, becomes possible and also the rate of introduction of such third component into the thin film may easily be controlled.

A second object of the present invention is to provide a method of forming a thin film on a substrate by means of a vacuum deposition techinque using of a new apparatus.

A third object of the present invention is to provide a new method of forming a amorphous silicon film by the use of an apparatus and a method hereinafter described in detail.

The other objects of the present invention will be explained hereinbelow with reference to drawings as examples.

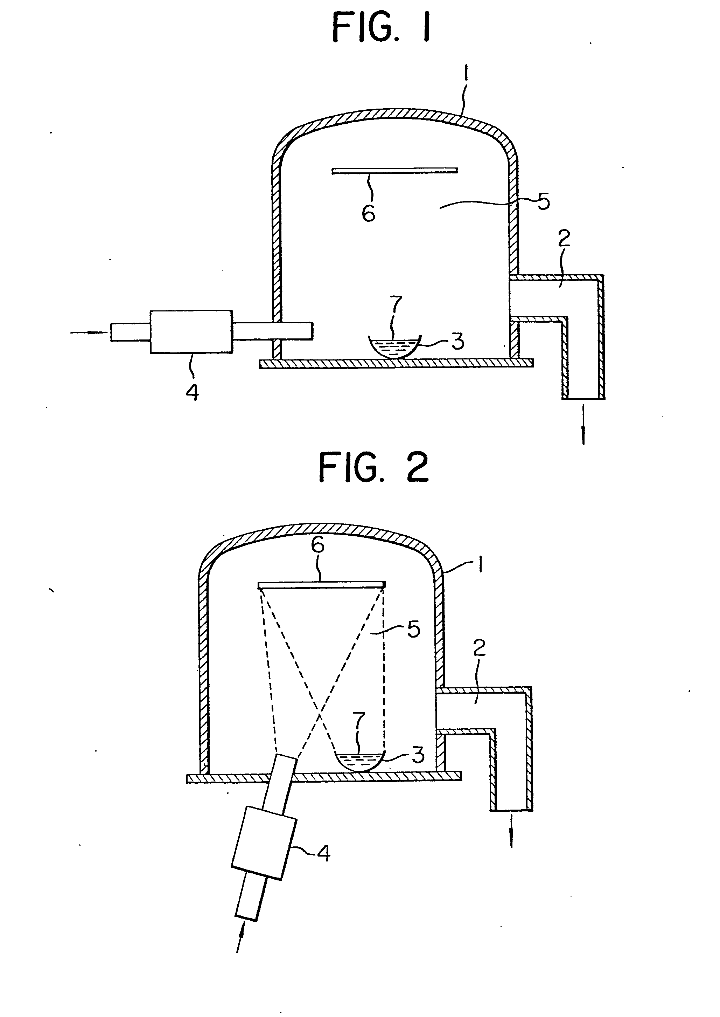

Fig.1 shows a representative arrangement of the apparatus of the present invention, Fig.'s 2 through 11 respectively illustrate preferable embodiments of the present invention, Fig.'s 12 through 14 illustrate the application of the apparatus and the method of the present invention to the formation of amorphous silicon film on a substrate while introducing, ionized hydrogen gas into the vacuum chamber and Fig.'s 15 through 18 illustrate examples of detailed structures of the discharge tube 4 of the present invention.

As illustrated in Figs. 1 to 3 the apparatus of the present invention comprises a chamber, which may be composed of a bell jar 1 and a table for the bell jar and the inside air of which is to be vacated by a vacuum pump (which is not shown in this drawing) through an exhaust path 2 which may be connected to said chamber in such manners as illustrated in Fig.'s 1 and 16, and a discharge tube 4 for activating and/or ionizing a gas to be supplied from a gas supplier (which is not shown in this drawing), which discharge tube is attached to said chamber, either through said bell jar 1 or through the table for the bell jar as illustrated in Fig's 1 and 2, so that an activated and/or ionized gas may be introduced into said chamber.

By the use of an apparatus of the present invention vacuum deposition will be carried out in the following manner, i.e., in the state that a material 6, on which surface film formation by vacuum deposition is to be effected (this material will be hereinafter refered to simply as "substrate"), is so arranged as to be placed opposite to a vapor source 7, with a vapor flying space 5 lying between, and that inside the bell jar 1 is kept at a vacuum condition, for example, at $10^{-6} - 10^{-2}$ Torr.

A vapor source 7 is evaporated by heating said source in the presence of an activated and/or ionized gas which is supplied into the chamber, and especially into the vapor flying area 5, through the discharge tube 4 from a gas supplier. Then, it is assumed that the activated and/or ionized particles of such gas is capable of activating the vaporized particles of said vapor source material 7 in the vapor flying space 5, or owing to various reactions including adsorption and diffusion at the surface of the substrate 6 on which a thin film will be formed, said vaporised particles alone or together with said activated and/or ionized particles deposit on the surface of said substrate 6, and thus a desired film will be formed at a considerably high speed. In other words, a film consisting only of the same substance as a vapor source, or a film consisting of said vapor source substance and a third component supplied from the discharge tube (hereinafter referred to as "discharge product") will be formed on the substrate 6.

Since this discharge product contains activated and/or ionized particles, if such discharge product is one capable of chemically reacting with said vapor source substance, they will react with each other and become a chemical compound. For example, oxide form of vapor source substance, such as those of indium, tin, and aluminium may be formed by supplying oxygen gas from the discharge tube 4. In the similar manner to that described above, other compounds such as those of nitride, hydride and halogenide may be obtained by selecting kind of gas to be supplied. Also, even if said discharge product is not capable of reacting chemically, it is possible to form an film of homogenized mixture which is very firmly bound with a substance of vapor source. Further, even in the case that the third component is the same substance with that of vapor source, it is possible to effectively form a film having strong physical properties because such third component provided by a discharge tube is active.

In the present invention, it is possible to control relatively easily the discharge condition by changing the supply amount of gas and discharge voltage etc. and thereby it is possible to increase the evaporation speed and, at the same time , it is possible to obtain a film with desired properties by controlling the concentration of such third component in the film.

Thus, with the present invention, high speed evaporation becomes possible by introducing a discharge product from the gas discharge tube 4 into the bell jar 1 and it is possible to form a film that comprises a specific vapor source substance and a third component with a high efficiency and at a controlled concentration and, therefore, it is possible to obtain a film made of a substance or substances which have not been obtainable by conventional methods.

As for the material used as vapor source 7, arbitrary substances which can be vaporised such as metal, metal oxide, semi-conductive substance, insulating substance and ferroelectric substance may be used and as to gases to be supplied to said gas discharge tube 4, such gases which are able to produce ion by way of discharge, for example, oxygen, nitrogen, hydrogen, ammonia, chlorine, fluorine, bromine, argon, krypton, xenon, etc. may be used.

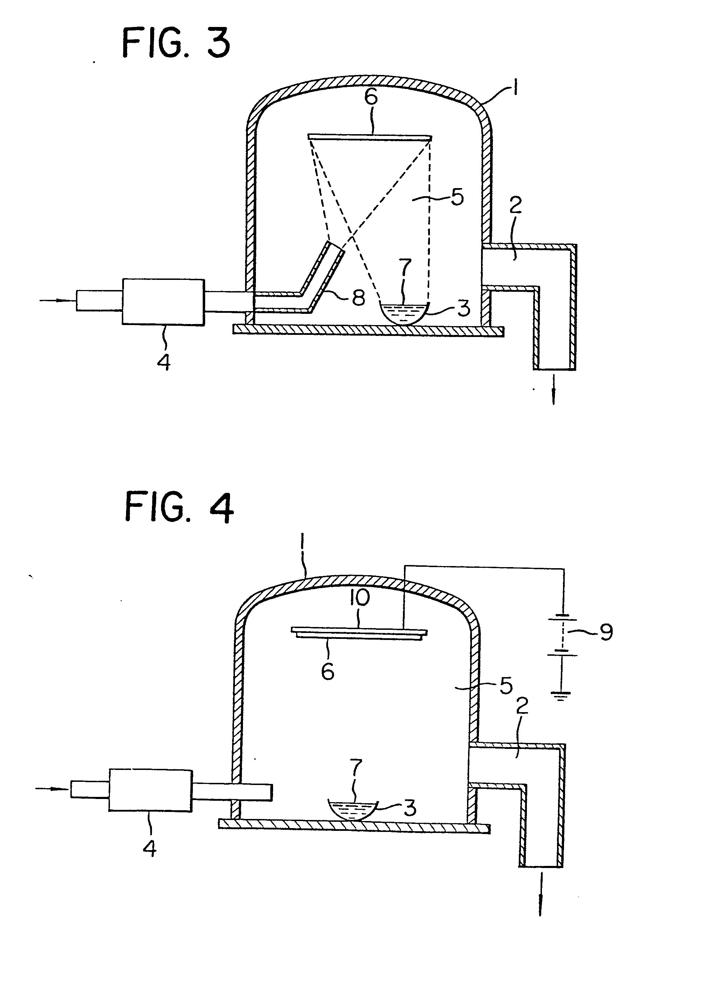

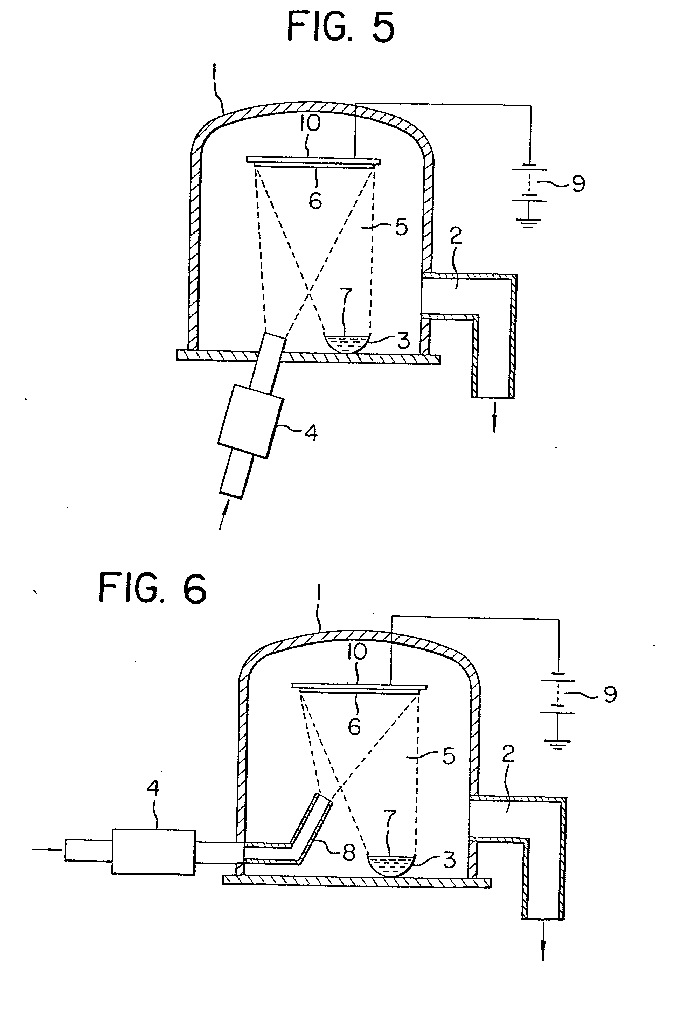

Figs. 4 to 6 and 13 and 14 illustrate a preferred feature of the present invention, that is to say, in the chamber is provided with an electrode 10 for accelerating deposition of ionized particles supplied from a discharge tube 4 on a substrate 6 , on the surface of which deposition is to be effected. This electrode 10 is placed opposite to a vapor source 7 with a vapor flying space 5 lying between, and more preferably, this electrode 10 is placed in the chamber so that substrate 6 may be placed on said electrode as shown in Fig.4. Further onto the electrode 10 negative or positive direct electric voltage, or alternating electric voltage may be supplied by a electric power source 9.

According to this embodiment the discharge product containing particles which have neither been activated nor ionized by discharge tube 4 as well as activated and/or ionized particles together with vaporized particles of the vapor source material 7 are in a mixed condition subject to glow discharge which is brought about by the action of the electrode 10 in the vapor flying space 5, with result that said non-ionized gas and the vapor may be ionized and these active particles come into collosion with said substrate and then precipitately adhere thereon. Thereby, high speed formation of a film on the substrate 6 becomes possible. When negative D.C. voltage is applied to said electrode 10, cations produced either in the discharge tube 4 or by glow discharge in the vapor flying space 5, will be accelerated by the electric potential of said electrode 10; and when positive D.C. voltage is applied thereto, electrons and other anions will flow into said electrode 10 and ionize the neiboring gas or vapor, which will result that the concentration of cation in the neiborhood of said electrode 10 becomes greater, and especially, when the electrode 10 itself serves concurrently as substrate,as the temperature thereof rises, the precipitate adhesion to the substrate 6 will be accelerated owing to said electron flow with the result that a film having elaborate composition may effectively be formed. Further, when alternating voltage is applied thereto, said glow discharge may be generated easily and maintained stably as well.

According to this embodiment of the invention, it is also possible to control the state of glow discharge by changing voltage applied to the electrode 10.

Above description only refers to the case where glow discharge takes place in the vacuum chamber, however, even under such gas pressure or a vapor density where no glow discharge takes place, if a negative voltage is applied to the electrode 10, cations produced by the gas discharge tube 4 may effectively be incorporated into a film and desirable inclusion of a third component into the film may be obtained.

Further, in the apparatus according to the present invention, it is, of course possible, like in an ordinary apparatus, to use, if necessary, a mechanism to heat the substrate.

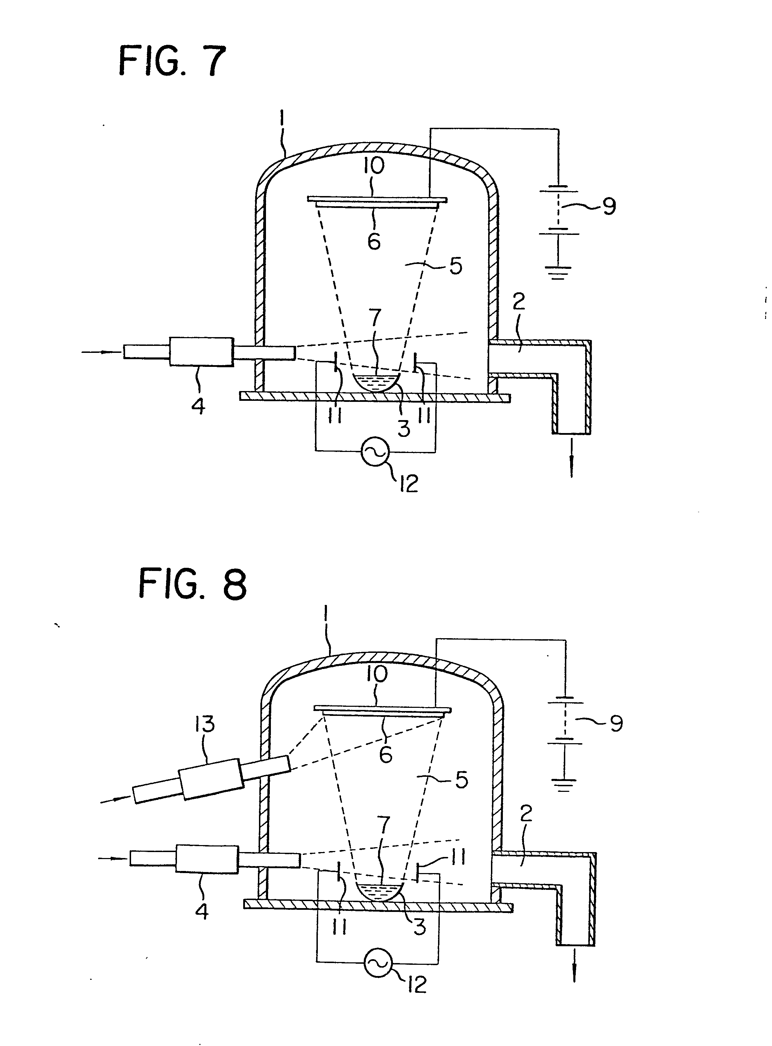

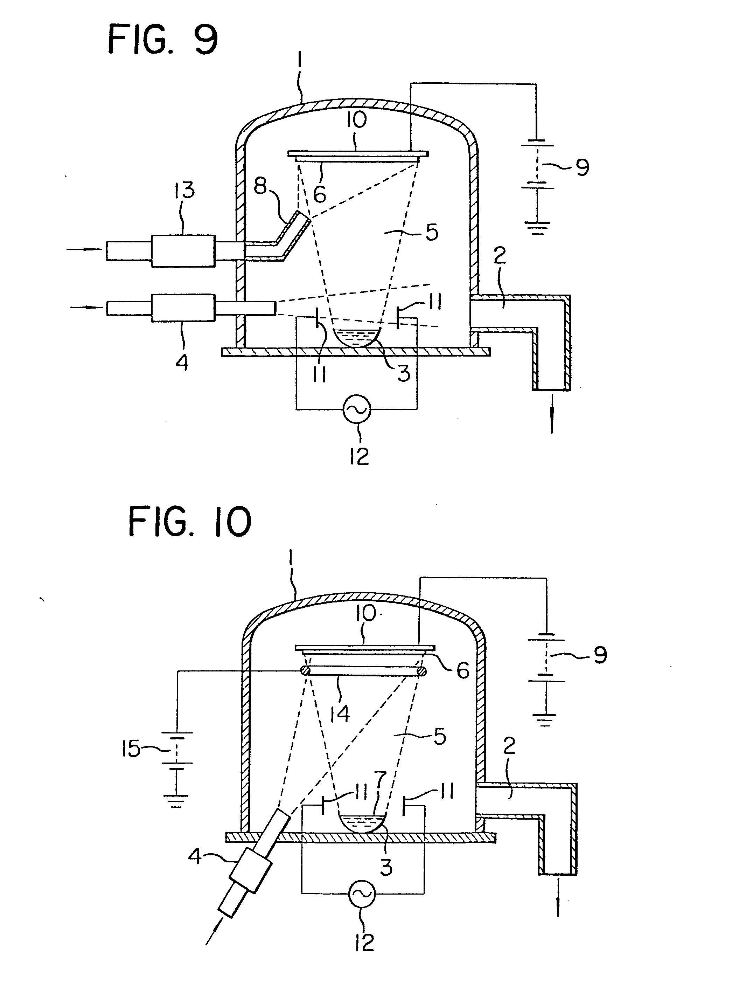

In Figs. 7 to 9 and 13 illustrate another preferable feature of the present invention, wherein the chamber is provided therein with at least one further electrode (11 in Fig.7) or, more preferably, with a pair of electrodes in the proximity of the vapor source 7. For example, in Fig.7 a pair of discharge electrodes 11 are provided so that they face opposite to each other right above vapor source 7, and the provided electrodes 11 may be impressed with an A.C. voltage by power source 12. Accelerating electrode 10 may also be provided above vapor source 7 so as to face opposite, with a vapor flying space 5 therebetween, to a vapor source 7 and the pair of electrodes 11. This accelerating electrode may be impressed with negative D.C. voltage of from 0 to -7 KV, preferably, from -100 V to -5 KV. And according to this embodiment, undercomposed gas vapor of the vapor source material become mixed to be subjected to a glow discharge in the space right above the vapor source 7 by the action of discharge electrodes 11, thus resulting in the ionization of the aforesaid undecomposed gas and vapor as well as the gas caused by recombination of the discharged products. The thus resulting cations are then accelerated by the negative electric potential of accelerating electrode 10 to be brought into collision and deposited on substrate 6.

Since the discharged products which are introduced into bell jar 1 have been activated or ionized and discharge electrodes 11 is provided in the proximity of vapor source 7, the glow discharge is very readily generated and stably maintained even when the evaporating gas pressure is small.

And according to this embodiment, not only is the discharging condition in gas discharge tube 4 relatively readily controllable by changing the gas supply quantity, discharge voltage, etc., but also the conditions for glow discharge may easily be controlled by changing the voltage impressed to the discharge electrodes 11 thereby enabling to increase deposition speed and to yield a film having desired properties by controlling the content of a third component.

Further, Figs. 10 and 11 illustrates still another feature of the present invention, wherein another electrode 14 for controlling discharge area is preferably placed between the electrode 10 for accelerating deposition of ionized particles and the other electrode for discharge 11 (or 21 in Fig.13) and this electrode 14 for controlling discharge area is preferably placed around circumference of the area where discharge by the electrode 10 for accelerating deposition of ionized particles and/or the electrode 11 (or 21 in Fig.13) for discharge may take place.

Still further, the construction may be so made that the first electrode 10 is placed opossite to the vapor source 7 with the vapor flying space 5 therebetween and negative DC voltage or AC voltage may be applied thereto by the power source 9, and either instead of this first electrode 10 or together with it, the second electrode 11 for discharge which consists of a pair of electrodes placed across the space above said vapor source 7 and AC voltage is applied thereto by a power source, and further, in order to control the discharge area formed by said first electrode 10 and/or second electrode for 11, an electrode 14 for controlling discharge area, that is of ring-or cylinder-shaped and extends along the external circumference of said vapor flying space 5, is placed and the positive DC voltage may be applied thereto by a power source 15.

According to this embodiment, since the electrode 14 for controlling discharge area is placed along the external circumference of vapor flying space 5, where glow discharge is generated, and positive voltage is applied to the electrode 14, it is possible to limit the area where said glow discharge generates to the space in front of the substrate 6. Further, electrons produced by the glow discharge can flow smoothly through said electrode 14 and at the same time cations are repelled by the electrode 14 and as a result, ion concentration near the substrate 6 will be increased and thereby, vacuum deposition with an extremely high efficiency will be possible.

In the present invention, as is shown in Fig.'s 2, 5, 10 it is preferable that the out-let mouth of the discharge tube 4 is so arranged that it directs directly to the substrate 6 in a bell jar 1, or alternatively, as is shown in Fig.'s 3, 6, 9 and 11, a joint 8 of any suitable shape may be connected to the out-let mouth of the discharge tube 4 so that the out-let mouth of said joint tube directs to the substrate 6. By this specific arrangement it will be possible to magnify a reaction or an interaction between vapor source substance and discharge products, thereby to form a film with increaced concentration of the third component. In the case when such reaction or interaction is too excessive, it will be also possible to adequately control the reaction or interaction by changing the length or the shape of the joint. Further it is possible, as is shown in Fig.'s 8 and 9, to arrange plural of discharge tubes so that at least one out-let mouth thereof may be directed to the substrate 6 and at least one other out-let mouth of other discharge tube is directed to, for example, the pair of electrodes for discharge 11.

We hereinafter explain of some examples of actual application of the present invention with reference to a method of producing amorphous silicon film which may suitably used as solar batteries, electrophotosensitive bodies, etc.

In recent years, the amorphous silicon obtained by the vapor phase grow method has been attracting public attention for its usefulness as solar batteries and the like. As a method for producing such amorphous silicon there can be mentioned a evaporation process based on the D.C. ion plating method, according to which method, a vacuum chamber is provided therein with a silicon vapor source and a substrate on which silicon from the vapor source is to be deposited, and the resulting vapor is irradiated with thermo electrons released from, e.g.,

a tungsten heater to activate and ionize the silicon vapor, and the thus produced silicon ions are brought into collision with the foregoing substrate impressed with negative D.C. voltage thereby to form an amorphous silicon over the surface of said substrate.  Further, in the above process the addition of hydrogen gas may be allowed to incorporate the gas into the silicon layer.

However, this D.C. ion plating method has such disadvantages that in this method it often becomes impossible to form an amorphous silicon film having predetermined properties due to the fact that the tungsten vapor evaporated from the tungsten heater for the purpose of releasing thermo electrons is often mixed as an undesirable impurity into the amorphous silicon film and also it is almost impossible to maintain evaporation velocity of the silicon vapor source below a certain limit which is necessary for the steady formation of the silicon film.

Further, there are present in the amorphous silicon formed in the above described manner a number of the so-called dangling bonds because of its irregularly arranged atomic structure, which is known as noncrystalloid. The dangling bond expresses a status where the electrons to form a bondage remain unbonded, or their covalent bonds are left severed. Such a condition often prevents necessary performance, e.g., photoelectric phenomenon, of silicon as a semiconductive material.

On the other hand, although there is known a method for blocking the dangling bonds by forming amorphous silicon from silicon ions produced by the decomposition of silane $(SiH_4)$ by glow discharge, and the concurrently produced activated hydrogen atoms are conducted into the resulting amorphous silicon, it is impossible in this method to arbitrarily change the concentration of the hydrogen atoms in the film, thus it is difficult to obtain any amorphous silicon having desired characteristics. Besides, there is also known a method wherein silicon is spattered in a hydrogen atmosphere, but the method has such a drawback that the layer forming velocity is slow.

According to the present invention it will become possible to provide a method which enables to readily produce amorphous silicon in which the foregoing dangling bonds are effectively blocked, thus possessing excellent properties as a semiconductive material.

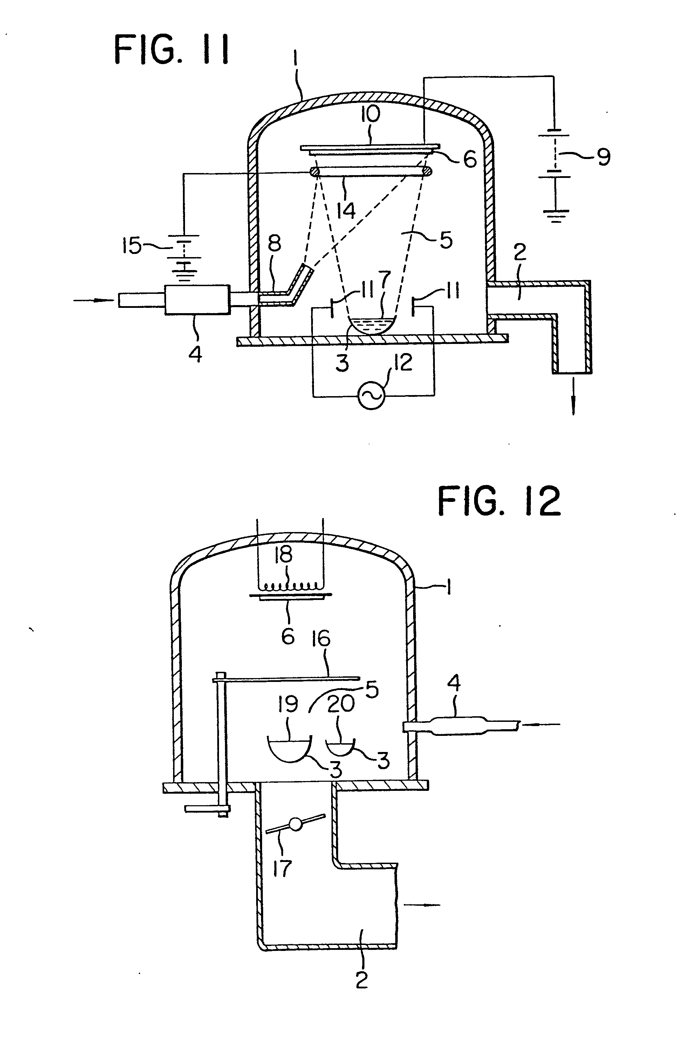

An example of the method for the formation of amorphous silicon is hereinbelow illustrated with reference to the drawing.  Fig.12 shows a bell jar 1 which provides a vacuum chamber and is connected through exhaust path 2 having a butterfly valve 17 with a vacuum pump which is hot shown in this drawing.  The inside of bell jar 1 is made in a vacuum condition, e.g., at $10^{-6}$ - $10^{-2}$ Torr.

Into the vacuum chmaber the ionized hydrogen obtained by subjecting hydrogen gas to discharge in a hydrogen discharge tube 4, that is connected to bell jar 1, is introduced, and inside the bell jar 1 silicon vapor source 19 is heated, in the presence of ionized hydrogen gas to vaporize the silicon which is, then, to be deposited to form amorphous silicon on the surface of substrate 6, which may be heated by a heating means 18.

The substrate 6 is disposed opposite, through shutter 16, to silicon vapor source 19, and as the heating means for silicon vapor source 19, an arbitrary heating means such as heating by resistance, electron beam gun, induction heating, can be used.  Temparature to be applied to heat the substrate 6, may vary from room temperature to about 500°C., preferably from 200°C to 300°C.

According to the invention silicon vapor from silicon vapor source 19 passes through a vapor flying space 5, where ionized hydrogen gas is present, and is deposited on substrate 6, and either during the period while silicon vapor is in the vapor flying space 5 or at the time of deposition on the substrate 6 the ionized hydrogen is incorporated into the vapor, thereby resulting in the formation on substrate 6 of amorphous silicon wherein dangling bonds are effectively blocked by hydrogen atoms.

In the present invention, since the activated hydrogen atoms containing ionized atoms to be incorporated into the amorphous silicon is produced and supplied by the hydrogen discharge tube 4, the quantity of the ionized hydrogen to be introduced into the bell jar 1 can easily be controlled by, e.g., varying the supply quantity of hydrogen gas to hydrogen discharge tube 4 or discharge voltage in the hydrogen discharge tube 4, etc. thus enabling to control the concentration of hydrogen incorporated into the amorphous silicon. Also, by appropriately selecting the shape and/or disposition of out-let mouth 29 of hydrogen discharge tube 4, efficient utilization of the ionized hydrogen and incorporation of hydrogen into the amorphous silicon at an increased concentration will become possible. Such selection would be particularly important in the case that the bell jar 1 is made of metal because when the ionized hydrogen is brought into collision with metal the ionized condition may be lost.

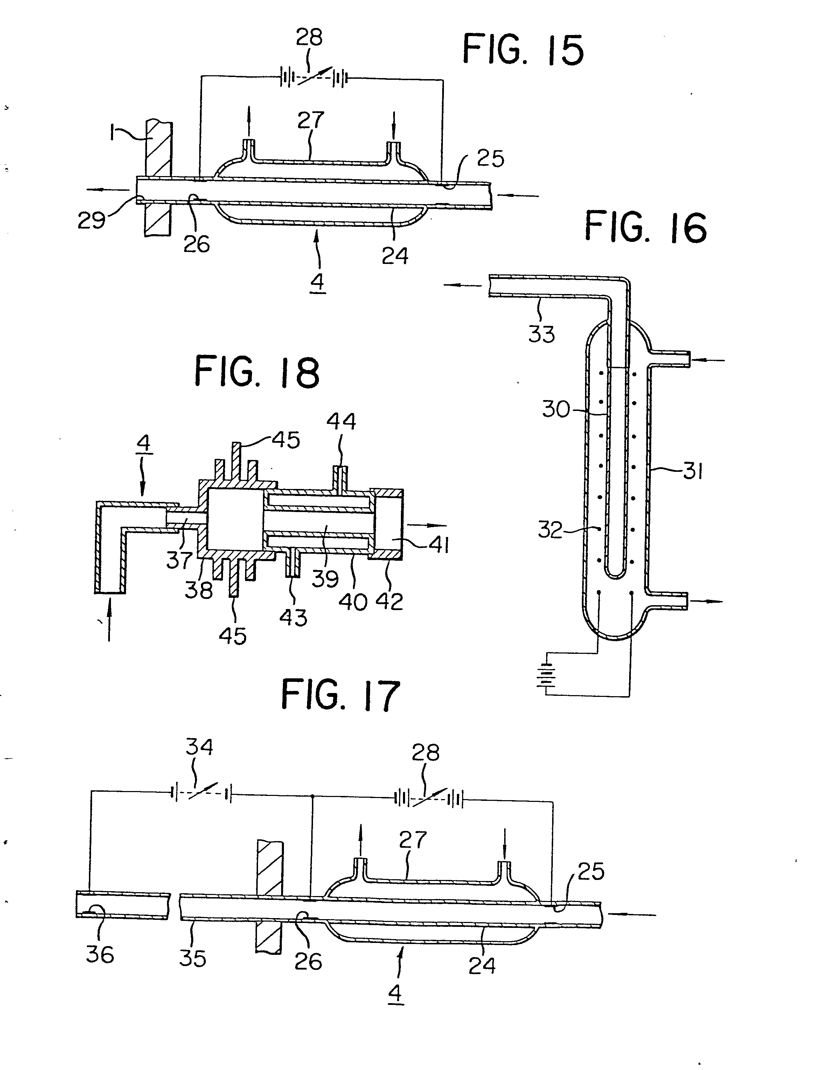

In order to avoid this disadvantage the out-let mouth of the discharge tube 4 may preferably be placed in the proximity of silicon vapor source 19 by extending the out-let portion of said discharge tube or by connecting thereto a joint tube 22 as shown in Fig's 13 or 14, and, thus, the bell jar 1 may be made of metal. Further, in order to avoid such disadvantage that the ionized hydrogen initially flowing through the glass pipe in the discharge tube tend to deposit on the interior surface thereof, it is also effective to provide a further electrode 36 (which is shown in Fig.17) at the end portion of the discharge tube or the joint tube 22 for accelerating the velocity of the ion flow.

Further, in the present invention, as shown in Fig.12 any additional vapor source 20 such as doping agent selected from phosphorus, arsenic, boron, antimony, etc., may be provided in the chamber, and thereby, it will be possible to produce amorphous silicon containing any necessary impurity, to make the amorphous silicon n-type or p-type semiconductor.

As agents for this purpose, such compounds as phosphine, arsine, diborane may also be used.

According to the present invention amophous silicon of desired quality may be obtained because the method of the present invention requires no member which produces undesireable impure vapor such as tungsten as in the D.C. ion plating method and also an amorphous silicon of desired properties may be obtained by arbitrarily controlling the unlimited velocity of the vapor from silicon vapor source 19.

Still further, the hydrogen pressure inside bell jar 1 which contains ionized hydrogen inside may easily be controlled to be at any level below $10^{-2}$ Torr by providing butterfly valve 17 in exhaust path 2, and thus the concentration of the hydrogen may be controlled to yield amorphous silicon having desired characteristics. The use of butterfly valve 17 as atmoshperic pressure control means makes possible to readily control the atmoshperic pressure in as extensive range as from $10^{-6}$ to $10^{-2}$ Torr.

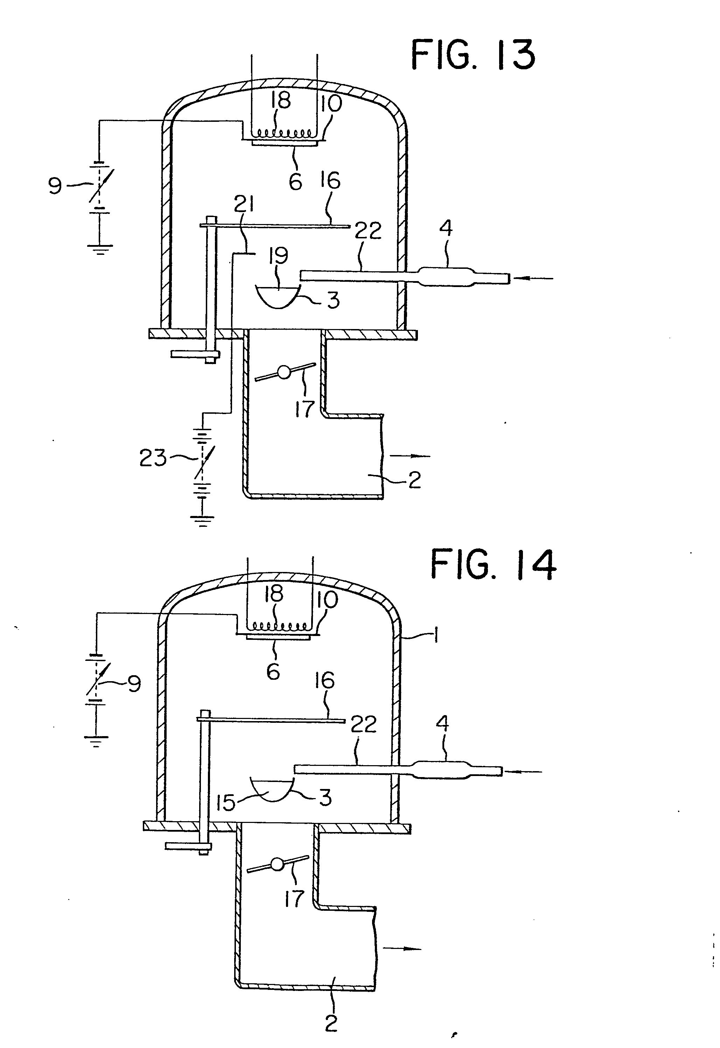

According to the preferable embodiment of the invention it is also possible for the substrate 6 to be impressed with 1 KV or less D.C. negative voltage by a power source 9 in Figs. 13 and 14 in order to accelerate the deposition of ionized hydrogen on the surface of substrate 6. By doing this, the hydrogen content ratio in the amorphous silicon may be increased.

It is, as a matter of course, possible to apply to this amorphous silicon producing method various variations described hereinbefore. For example as shown in Fig.13, this method may be carried out by providing an electrode 21 for glow discharge in the chamber and effecting glow discharge.

The following brief description further illustrates the present invention.

While heating substrate 6 made of a quartz plate to 200°C and introducing ionized hydrogen into the bell jar 1 from the discharge tube 4 under the conditions of 550 V of discharge voltage and 0.8 A of discharge current in hydrogen discharge tube 4 silicon vapor source 19 was heated and vaporized by an electron beam gun for 10 minutes, and thus hydrogenated amorphous silicon film was formed on the substrate 6. The depositing velocity at this time was 1000 A/min. The so-called optical gap of the hydrogenated amorphous silicon layer was about 1.9 eV.; the light response was $10^{15}$ photons/$cm^2$. Sec. in 5500A, and the resistance variation was $10^{-7}$ $(\Omega \cdot cm)^{-1}$.

Fig.15 shows a detailed structure of a hydrogen discharge tube 4, which comprises a hydrogen supply pipe 24 made of glass through which hydrogen gas flows, discharge electrodes 25 and 26 provided inside the hydrogen supply pipe 24, and mantle tube 27 for cooling provided around said hydrogen supply pipe 24. Discharge is generated between discharge electrodes 25 and 26 by the voltage from a power source 28 under such conditions that the hydrogen gas pressure in the foregoing discharge region is maintained at below $10^{-2}$ Torr, whereby part of the hydrogen gas is ionized to produce ionized hydrogen, which is then introduced together with other activated and non-activated hydrogen gas through the out-let mouth 29 of the hydrogen discharge tube into bell jar 1. Cooling water flows in mantle tube 27 to prevent the supply pipe from becoming overheated.

The distance between discharge electrodes 25 and 26 may be normally from 10 to 15 cm, while the voltage to be impressed may be from 500 to 800 V. And the opposite polarity to that shown in Fig.15 may also be impressed to the electrode to sufficiently achieve the purpose. Further, in order to generate discharge to the hydrogen gas, a high frequency power source may also be used in place of the D.C. power source. In this way not only highly sufficient discharge becomes possible but also contamination of the vacuum chamber by impurities resulting from the material of discharge electrodes 25 and 26 may be eliminated because,according to this method,only provision of a high frequency coil around hydrogen supply pipe 24 is necessary and exposing of the discharge electrodes 25 and 26 to the hydrogen gas flow inside the hydrogen supply pipe 24 will be avoided.

As for hydrogen gas to be supplied into hydrogen discharge tube 4, although that from an ordinary hydrogen gas cylinder may be used as it is, the use of pure hydrogen gas is desirable in order to eliminate the mixing of undesirabel impurities into the amorphous silicon. Various means for obtaining pure hydrogen gas are known, and for example, such a hydrogen purifier as shown in Fig.16 may conveniently be used, which is composed of an inner tube 30 made of palladium, an outer tube 31 surrounding said inner tube 30, and a heater 32 for heating the inner tube 30.  By the use of this purifier, while heating the inner tube 30 by heater 32, the original hydrogen gas from a hydrogen gas cylinder is supplied into inside of the outer tube 31.  Then, the hydrogen gas permiates through the wall of inner tube 30 to become purified, and as a result a highly purified hydrogen gas can be obtained from an out-let pipe 33.

Further as shown in Fig.17, the discharge tube 4 may be provided with an electrode 36 and power source 34 in order to accelerate the ionized hydrogen.

Fig.18 illustrates another example of discharge tube 4.  This discharge tube 4 comprises a cylindrical electrode member 38 including a gas inlet 37, a cylindrical member for discharge space 40 which is made of for instance glass, being connected to said electrode member 38 on one end thereof and surrounding a discharge space 39, and a ringshaped electrode member 42 being provided on the other end of said member for discharge space and having an out-let 41.  The member for discharge space 40 illustrated in Fig. 18 has a double-pipe construction and cooling water can pass therethrough from an in-let 43 to an out-let 44.

And 45 of this drawing shows a fin for cooling purpose.

When carrying out vacuum deposition suitable gas is supplied from the in-let 37 and the electrode member 38 is negatively charged (e.g., -600 V) and the electrode member 41 is grounded and the gas subject to discharge in the discharge space 39, and thereby said gas is decomposed to produce cation, anion or active particles such as electrons which is introduced into the bell jar 1 by atmospheric pressure or concentration difference between the discharge space 39 and the chamber, or accelerated by the electrode member 42.

As mentioned above, according to the present invention, it is possible to carry out vacuum deposition at high speed with an extremely simple construction and it is possible to form with an improved efficiency a thin film which is composed not only of any specific component from vapor source but also of a third component and since the proportion of each component can easily be controlled, it is possible to obtain a film with desired composition and suitable properties.

Further, according to the invention as hereinabove described amorphous silicon whose dangling bonds are blocked by hydrogen atoms can be obtained in an easy and efficient manner, and, therefore ,such amorphous silicon which has excellent properties as a semiconductive material can be obtained.

CLAIMS

1.    An apparatus for vacuum deposition of a film on a
substrate from a vapour source, said apparatus comprising
a chamber (1), and an exhaust path (2) by which the chamber
can be evacuated, characterised by a discharge tube (4) for
activating or ionizing a gas, said discharge tube (4) being
connected to said chamber (1) so that an activated or ionized
gas may be introduced into said chamber (1).

2.    An apparatus according to claim 1, characterised by
an electrode (10) for accelerating deposition of ionized
particles on a substrate (6) from the vapour source (3)
when the vapour source is opposite the electrode (10) in
the chamber (1).

3.    An apparatus according to claim 1 or 2 characterised
in that there is provided within said chamber (1) at least
one electrode (11) for discharge adjacent the location of
a vapour source (13).

4.    An apparatus according to claim 3 characterised by
at least one further discharge tube (13) extending into
said chamber (1) for introducing an activated or ionized
gas, the out-let mouth of said one discharge tube (4)
being directed to said at least one electrode (11) and the mouth
of said other discharge tube (13) being directed to the substrate.

5.    An apparatus according to claim 2, 3 or 4 characterised in that there is provided within said chamber (1) an electrode (14) for controlling discharge area, said electrode (14) being between a substrate (6) and vapour source (3), and being further from said the substrate and vapour source than, respectively and where provided, said electrode (10) for accelerating deposition and said at least one electrode (11) for discharge, and extending around the area where discharge caused by said electrode (10) for accelerating deposition and/or said at least one electrode (11) for discharge may take place.

6...  An apparatus according to claim 1, 2, 3 or 4 or 5 characterised in that said discharge tube (4) is located outside said chamber (1) and extending thereinto.

7.    An apparatus according to claim 1, 2 or 3 characterised in that the out-let mouth of said discharge tube (4) is directed to towards the substrate (6).

8.    A method of vacuum deposition of a film on a substrate from a vapour source in a vacuum chamber, characterised by the step of supplying ionized gas to the chamber by a discharge tube for activating or ionizing gas, the out-let mouth of said discharge tube being within said vacuum chamber or at the inner surface thereof.

9.    A method according to claim 8, characterised in that an electrode for accelerating deposition of ionized particles on a substrate is provided opposite the vapour source in said vacuum chamber.

10.   A method according to claim 9, wherein said substrate is on said electrode and a negative D.C. voltage is impressed on said electrode.

11.   A method according to claim 8, 9 or 10 characterised in that said vacuum chamber is provided with at least one electrode for discharge adjacent the location of the vapour source.

12.   A method according to claim 11, wherein A.C. voltage is supplied to a pair of electrodes for discharge.

13.   A method according to claim 11 or 12 characterised in that ionized gas is also supplied to the chamber by at least one further discharge tube, the out-let mouth of the first said discharge tube being directed to said at least one electrode for discharge and the out-let mouth of said at least one further discharge tube being directed towards the substrate.

14. A method according to claim 9, 10, 11, 12 or 13 characterised in that an electrode for controlling discharge area is provided between the substrate and vapour source, and is further from them than, respectively and where provided, the electrode for accelerating deposition and the electrode for discharge and extends around the area where discharge caused by said electrode for accelerating deposition and/or said at least one electrode for discharge take place.

15. A method according to claim 8, 9, 10, 11 or 12 characterised in that the out-let mouth of said discharge tube is directed towards the substrate.

16. A method according to any one of claims 8 to 15, wherein said vapour source consists of silicon and said activated or ionized gas contains ionized hydrogen.

17. A method according to any one of claims 8 to 16, wherein the inside of said vacuum chamber is maintained at below $10^{-2}$ Torr.

18. A method according to any one of claims 8 to 17, wherein a doping agent is further provided inside said vacuum chamber as a vapour source.

FIG. I

FIG. 2

# FIG. 3

# FIG. 4

## FIG. 5

## FIG. 6

FIG. 7

FIG. 8

# FIG. 9

# FIG. 10

FIG. 11

FIG. 12

# FIG. 13

# FIG. 14

FIG. 15

FIG. 16

FIG. 18

FIG. 17

# EUROPEAN SEARCH REPORT

European Patent Office

| | DOCUMENTS CONSIDERED TO BE RELEVANT | | CLASSIFICATION OF THE APPLICATION (Int. Cl.³) |
|---|---|---|---|
| Category | Citation of document with indication, where appropriate, of relevant passages | Relevant to claim | |
| | US – A – 3 980 044 (E. ZOLLINGER)<br><br>* claims 1,3; column 4, lines 6-10 *<br><br>-- | 1,2,6, 8,9,17 | C 23 C 13/00 |
| | US – E – 26 857 (M. AUWARTER)<br><br>* figure 8; column 9, lines 39-55; column 1, lines 50-54 *<br><br>-- | 1,8 | |
| | DE – B – 1 104 283 (A. VOGT)<br><br>* claims 1,7; column 12, line 60 - column 13, line 3; figure 8 *<br><br>-- | 1,8 | TECHNICAL FIELDS SEARCHED (Int. Cl.³)<br><br>C 23 C 13/00 |
| | US – A – 3 551 312 (D. KAHNG et al.)<br><br>* column 2, lines 22-36; column 2, line 71 - column 3, line 8 *<br><br>-- | 1,8 | |
| | WO – A – 79/00724 (ENERGY CONVERSION DEVICES INC.)<br><br>* claims 1,6,8,9,13; figure 1; page 17, line 2 - page 20, line 3 *<br><br>-- | 1,16, 18 | |
| A | US – A – 3 583 361 (A. LAUDEL)<br><br>* figures; column 2, lines 28-35 *<br><br>-- | 3,11 | |
| | | ./. | |

The present search report has been drawn up for all claims

| Place of search | Date of completion of the search | Examiner |
|---|---|---|
| The Hague | 25-02-1981 | FISCHER |

EPO Form 1503.1  06.78

| Category | Citation of document with indication, where appropriate, of relevant passages | Relevant to claim |
|---|---|---|
| A | US - A - 3 953 619 (K. MATSUBARA)<br><br>* claim 1 *<br><br>-- | 5,14 |
| A | SOLID STATE COMMUNICATIONS, vol. 20, no. 10, 1976<br>Pergamon Press<br>(GB)<br>W. PAUL et al.:"Doping, Schottky Barrier and p-n Junction Formation in Amorphous Germanium and Silicon by rf Sputtering"<br>pages 969-972<br><br>* page 969 *<br><br>-- | 16,18 |
| A | SOLID STATE COMMUNICATIONS, vol. 23, no. 3, 1977<br>Pergamon Press<br>(GB)<br>T.D. MOUSTAKAS et al.:"Preparation of Highly Photoconductive Amorphous Silicon by rf Sputtering"<br>pages 155-157<br><br>* page 155 *<br><br>-- | 16,18 |
| P | FUNKSCHAU, vol. 52, no. 3, February 1980<br>MUNICH (DE)<br>"Solarzellenherstellung mit Gleichstrom-Ionen-Plattierung"<br>page 14<br><br>* the whole document * | 16,18 |

DOCUMENTS CONSIDERED TO BE RELEVANT

CLASSIFICATION OF THE APPLICATION (Int. Cl. 3)

TECHNICAL FIELDS SEARCHED (Int. Cl. 3)